(19) **Europäisches Patentamt**

**European Patent Office**

**Office européen des brevets**

(11) **EP 1 098 313 A2**

(12) **EUROPEAN PATENT APPLICATION**

(43) Date of publication:
09.05.2001 Bulletin 2001/19

(51) Int. Cl.[7]: **G11B 20/10**, G11B 20/18, H03H 21/00

(21) Application number: 00309356.4

(22) Date of filing: 24.10.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 04.11.1999 KR 9948585

(71) Applicant:
**SAMSUNG ELECTRONICS CO., LTD.**
**Suwon-City, Kyungki-do (KR)**

(72) Inventor: **Shim, Jae-seong**
Seoul (KR)

(74) Representative:
**Chugg, David John et al**
**Appleyard Lees,**
**15 Clare Road**
**Halifax, West Yorkshire HX1 2HY (GB)**

(54) **Data reproduction apparatus and method with improved performance by adjusting filter coefficients of equalizer**

(57) A data reproduction apparatus and method capable of improving data reproduction performance by adjusting the filter coefficients of an equalizer (106) including a digital filter, and connected before a Viterbi detector (114). A level of the output value of the equalizer (106) is detected based on a reference level set in the Viterbi detector (114), and a level error of the detected level with respect to a predetermined reference value is detected. The filter coefficients of the equalizer (106) are adjusted such that the level error is minimized, thereby improving the detection performance of the Viterbi detector (114).

FIG. 3

EP 1 098 313 A2

## Description

The present invention relates to the field of data reproduction, and more particularly, to a data reproduction apparatus and method with optimum performance by adjusting filter coefficients for an equalizer to minimize a level error in detecting data.

As a technique for increasing recording density by signal processing without changing the characteristics of a conventional recording/reproducing apparatus, partial response maximum likelihood (PRML) related technique, including Viterbi decoding, has advanced, and there have been various suggestions for its implementation.

Viterbi decoders have a predetermined reference level for use in detecting an error value of data. To match the level of input data of a Viterbi decoder to the predetermined reference level, filter tap coefficients of an equalizer connected in front of the Viterbi detector are adjusted to output data whose level matches the reference level of the Viterbi detector.

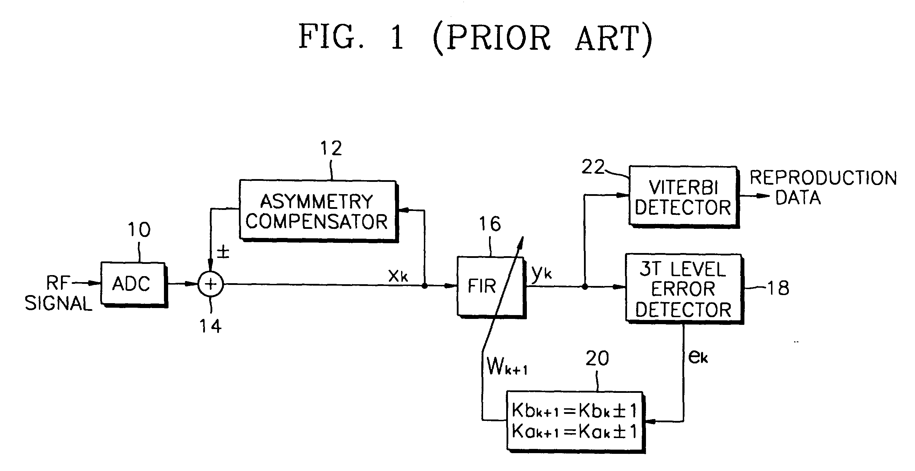

Figure 1 illustrates a coefficient adaptation method of a conventional equalizer. An analog-to-digital converter (ADC) 10 samples an input radio frequency (RF) signal, and an asymmetry compensator 12 and an adder 14 correct for asymmetry or a DC offset component of the sample RF signal and provides the result to an equalizer 16. A 3T level error detector 18 detects a difference, i.e., error ($e_k$), between a reference value and the minimum pit (or mark) level, which corresponds to 3T (where T is a pit interval) in a conventional digital versatile disc (DVD) or compact disc (CD)), output from the equalizer 16 which is constituted of a finite impulse response (FIR) filter.

If the error value detected by the 3T level error detector 18 is a positive value, a filter coefficient adjuster 20 determines that the minimum pit level is larger than the reference value. In this case, the filter coefficient adjuster 20 provides the equalizer 16 with a filter coefficient $W_{k+1}$, which is adjusted to decrement a filter coefficient $K_b$ and increment a filter coefficient $K_a$, to decrease the minimum pit level output from the equalizer 16. On contrary, if the error value detected by the 3T level error detector 18 has a negative value, the filter coefficient adjuster 20 determines that the minimum pit level is smaller than the reference value. As a result, the filter coefficient adjuster 20 provides the equalizer 16 with the filter coefficient $W_{k+1}$, which is adjusted to increment the filter coefficient $K_a$ and decrement the filter coefficient $K_b$, to increase the minimum pit level output from the equalizer 16. The minimum pit level is adjusted to an appropriate level in the above manner, so that the performance of the Viterbi detector 22 is enhanced.

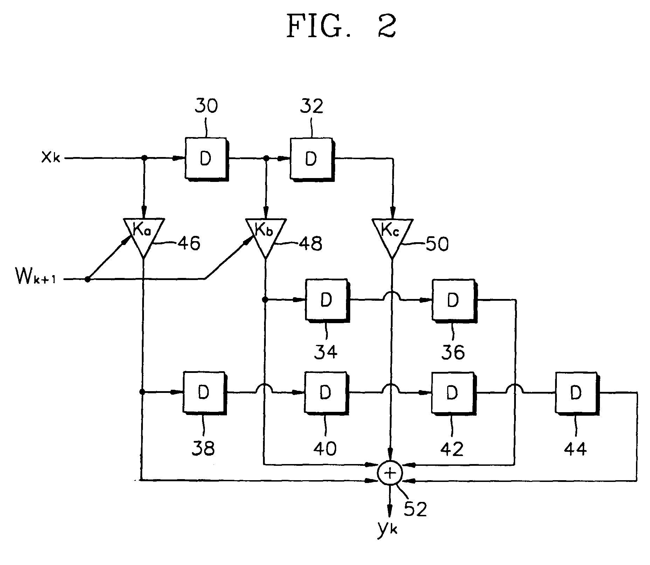

Figure 2 illustrates the structure of the equalizer 16. In Figures 1 and 2, $x_k$ indicates data input to the equalizer 16, $y_k$ indicates data output from the equalizer 16, and $W_{k+1}$ indicates the filter coefficient for the equalizer 16 after coefficient adaptation. Reference numerals 30, 32, 34, 36, 38, 40, 42 and 44 denote delays, reference numerals 46, 48 and 50 denote coefficient multipliers, and reference numeral 52 denotes an adder.

With the structure of the conventional equalizer, detection of the minimum pit level is difficult and level error detection is restricted because only the middle level of the minimum pit is used. Thus, it is difficult to expect a great improvement in reproduction performance. In addition, even though defocusing occurs, the coefficient adaptation in the conventional equalizer ensures the improvement of reproduction performance, by adjusting filter coefficients. However, the conventional equalizer cannot be adopted when the coefficients of the equalizer asymmetrically vary due to tangential tilting.

With a view to solve or reduce the above problems, it is an aim of embodiments of the present invention to provide a data reproduction apparatus and method with improved performance, which can be adopted for a recording medium such as an optical disk.

It is a second aim of embodiments of the present invention to provide a data reproduction apparatus and method with improved performance, which selects filter coefficients for an equalizer such that a level error is minimized.

It is a third aim of embodiments of the present invention to provide a data reproduction apparatus and method with improved performance, which adaptively selects filter coefficients for an equalizer such that a level error is minimized.

It is a fourth aim of embodiments of the present invention to provide a data reproduction apparatus and method capable of monitoring the servo status, such as the direction of tangential tilting, or defocusing status, according to variations in filter coefficients.

It is a fifth aim of embodiments of the present invention to provide a data reproduction apparatus and method with improved performance, which adaptively selects filter coefficients for an equalizer, in consideration of the servo status, such as the direction of tangential tilting, or defocusing status, according to variations in filter coefficients.

According to a first aspect of the present invention, there is provided a data reproduction apparatus including a data detector for detecting data based on partial response maximum likelihood (PRML), the apparatus comprising: an equalizer comprising a digital filter; a level error detector for extracting a level of the output value of the equalizer based on a reference level set in the data detector, and detecting a level error between the level of the output value and a predetermined reference value; a coefficient bank for storing filter coefficients of the equalizer; and a coefficient selector for selecting the filter coefficients of the equalizer from the coefficient bank such that the level error is minimized.

Preferably, the error detector predetermines at least one reference value corresponding to zero level, positive and negative middle levels, and positive and negative maximum levels, which are classified depending on the partial response (PR) type of the data detector and detects the levels from the output value of the equalizer, and outputs the level error corresponding to differences between the detected levels and corresponding reference values.

The error detector may determine whether or not the product of two successive sampling data output from the equalizer is less than 0, determines which one of the sampling data is greater than 0 if the product of the two successive sampling data is less than 0, determines the sampling data greater than 0 as the positive middle level, and the sampling data less than 0 as the negative middle level, and detects level errors corresponding to the differences between the values of the sampling data determined as the positive and negative middle levels, and corresponding reference values.

The error detector may determine whether or not all three successive sampling data output from the equalizer are greater than a predetermined threshold value, determines the middle sampling data as the positive maximum level if all of the three successive sampling data are greater than the predetermined threshold value, and determines the middle sampling data as the negative maximum level if all of the three successive sampling data are less than the predetermined threshold value, and detects level errors corresponding to the differences between the values of the sampling data determined as the positive and negative maximum levels, and corresponding reference values.

The error detector may determine whether or not the product of two successive sampling data output from the equalizer is less than or equal to 0, and determines the sampling data whose absolute value is less than the absolute value of the other sampling data as the zero level, and detects the difference between the value of the sampling data determined as the zero level and a corresponding reference value.

The error detector may determine whether the product of two successive sampling data output from the equalizer is less than or equal to 0, compares the absolute values of the two successive data if the product of two successive sampling data output from the equalizer is less than or equal to 0, determines the latter of the two successive sampling data, and the sampling data preceding the two successive sampling data to be the positive and negative middle levels, respectively, if the absolute value of the latter of the two successive sampling data is greater than that of the other sampling data, determines the sampling data preceding the two successive sampling data, and the sampling data following the two successive sampling data to be the positive and negative middle levels, respectively, if the absolute value of the former of the two successive sampling data is and greater than or equal to the other sampling data, and detects level errors corresponding to the differences between the values of the sampling data determined as the negative and positive middle levels, and corresponding reference values.

The coefficient bank may store the filter coefficients of the equalizer, which are adapted according to the servo status and the degree of defocusing and tangential tilting.

The coefficient selector may select coefficients stored in the coefficient bank according to a coefficient change request signal input from the outside to replace the filter coefficients of the equalizer with the selected coefficients, checks the level error output from the level error detector, and determines the coefficients which minimize the level error to be the final filter coefficients of the equalizer.

According to another aspect of the invention, there is provided a data reproduction apparatus including a data detector for detecting data based on partial response maximum likelihood (PRML), the apparatus comprising: an equalizer comprising a digital filter; a level error detector for extracting a level of the output value of the equalizer based on a reference level set in the data detector, and detecting a level error between the level of the output value and a predetermined reference value; and a coefficient adapter for adapting filter coefficients of the equalizer such that a difference between the level error and a target level error is minimized.

Preferably, the error detector predetermines at least one reference value corresponding to zero level, positive and negative middle levels, and positive and negative maximum levels, which are classified depending on the partial response (PR) type of the data detector and detects the levels from the output value of the equalizer, and outputs the level error corresponding to differences between the detected levels and corresponding reference values.

The error detector may determine whether or not the product of two successive sampling data output from the equalizer is less than 0, determines which one of the sampling data is greater than 0 if the product of the two successive sampling data is less than 0, determines the sampling data greater than 0 as the positive middle level, and the sampling data less than 0 as the negative middle level, and detects level errors corresponding to the differences between the values of the sampling data determined as the positive and negative middle levels, and corresponding reference values.

The error detector may determine whether or not all three successive sampling data output from the equalizer are greater than a predetermined threshold value, determines the middle sampling data as the positive maximum level if all of the three successive sampling data are greater than the predetermined threshold value, and determines the middle sampling data as the negative maximum level if all of the three successive sampling data are less than the predetermined threshold value, and detects level errors corresponding to the differences between the values of the sampling data determined as the positive and negative maximum levels, and corresponding reference values.

The error detector may determine whether or not the product of two successive sampling data output from the equalizer is less than or equal to 0, and determines the sampling data whose absolute value is less than the absolute value of the other sampling data as the zero level, and detects the difference between the value of the sampling data determined as the zero level and a corresponding reference value.

The error detector may determine whether the product of two successive sampling data output from the equalizer is less than or equal to 0, compares the absolute values of the two successive data if the product of two successive sampling data output from the equalizer is less than or equal to 0, determines the latter of the two successive sampling data, and the sampling data preceding the two successive sampling data to be the positive and negative middle levels, respectively, if the absolute value of the latter of the two successive sampling data is greater than that of the other sampling data, determines the sampling data preceding the two successive sampling data, and the sampling data following the two successive sampling data to be the positive and negative middle levels, respectively, if the absolute value of the former of the two successive sampling data is and greater than or equal to the other sampling data, and detects level errors corresponding to the differences between the values of the sampling data determined as the negative and positive middle levels, and corresponding reference values.

The data reproduction apparatus may further comprise a defocus/tilt detector for detecting the servo status by monitoring variations of the adaptive filter coefficients of the equalizer.

The defocus/tilt detector preferably determines a state where both side tap coefficients around the central tap coefficient of the equalizer increase to be a state of defocus, and outputs a defocus signal.

The defocus/tilt detector may determine a state where one side tap coefficient with respect to the central tap coefficient of the equalizer increases while the opposite side tap coefficient decreases to be a state of tangential tilting, and outputs a tangential tilt signal.

The defocus/tilt detector may determine the direction of the tangential tilting according to which side tap coefficient increases or decreases with respect to the central tap coefficient.

According to another aspect of the invention, there is provided a data reproduction method capable of improving the performance of a data detector for detecting data based on partial response maximum likelihood (PRML) by adjusting filter coefficients of an equalizer comprising a digital filter, connected before the data detector, the method comprising the steps of: (a) extracting a level of the output data of the equalizer based on a reference level set in the data detector, and detecting a level error between the level of the output data and a predetermined reference value; and (b) adjusting the filter coefficients of the equalizer such that the level error is minimized.

Preferably, in step (a), at least one reference value corresponding to zero level, positive and negative middle levels, or positive and negative maximum levels, which are classified depending on the partial response (PR) type of the data detector is predetermined, a level of the output value of the equalizer is detected based on the classified levels, and the level error is detected corresponding to differences between the detected levels and corresponding reference values.

Step (a) may comprise: (a1) determining whether or not the product of two successive sampling data output from the equalizer is less than 0, determining which one of the sampling data is greater than 0 if the product of the two successive sampling data is less than 0, determining the sampling data greater than 0 as the positive middle level, and the sampling data less than 0 as the negative middle level; and (a2) detecting level errors corresponding to the differences between the values of the sampling data determined as the positive and negative middle levels, and corresponding reference values.

Step (a) may comprise: (a1) determining whether or not all three successive sampling data output from the equalizer are greater than a predetermined threshold value, determining the middle sampling data as the positive maximum level if all of the three successive sampling data are greater than the predetermined threshold value, and the middle sampling data as the negative maximum level if all of the three successive sampling data are less than the predetermined threshold value; and (b) detecting level errors corresponding to the differences between the values of the sampling data determined as the positive and negative maximum levels, and corresponding reference values.

Step (a) may comprise: (a1) determining whether or not the product of two successive sampling data output from the equalizer is less than or equal to 0, and determining the sampling data whose absolute value is less than the absolute value of the other sampling data as the zero level; and (a2) detecting the difference between the value of the sampling data determined as the zero level and a corresponding reference value.

Step (a) may comprise: (a1) determining whether or not the product of two successive sampling data output from the equalizer is less than or equal to 0, and comparing the absolute values of the two successive data; (a2) determining the latter of the two successive sampling data, and the sampling data preceding the two successive sampling data to be the positive and negative middle levels, respectively, if the absolute value of the latter of the two successive sampling data is greater than that of the other sampling data; (a3) detecting level errors corresponding to the differences between the values of the sampling data determined as the negative and positive middle levels in step (a2), and corresponding reference values; (a4) determining the sampling data preceding the two sampling data, and the latter of the two successive sampling data to be the positive and negative middle levels, respectively, if the absolute value of the former of the two successive sampling data is greater than or equal to the ether sampling data; and (a5) detecting level errors corresponding to the differences between the values of the sampling data determined as the negative and positive middle levels in step (a4), and corresponding reference values.

In step (b) the filter coefficients of the equalizer may be adapted according to the servo status and the degree of defocusing and tangential tilting.

In step (b) the filter coefficients of the equalizer may be changed according to a coefficient change request signal input from the outside, and the level error is continuously checked to determine the coefficients which minimize the level error as the final filter coefficients of the equalizer.

In step (b) the filter coefficients of the equalizer may be adapted such that a difference between the level error and a target level error is minimized.

The data reproduction method may further comprise (c) monitoring the adaptive filter coefficients of the equalizer and determining the servo status according to the variations of the adaptive filter coefficients.

In step (c) when both side tap coefficients around the central tap coefficient of the equalizer increase, the state may be determined to be a state of defocus.

In step (c) when one side tap coefficient with respect to the central tap coefficient increases while the opposite side tap coefficient decreases, the state may be determined to be a state of tangential tilting.

In step (c) the direction of the tangential tilting may be detected according to which side tap coefficient increases or decreases.

For a better understanding of the invention, and to show how embodiments of the same may be carried into effect, reference will now be made, by way of example, to the accompanying diagrammatic drawings in which:

Figure 1 illustrates a coefficient adaptation method of a conventional equalizer;

Figure 2 illustrates the structure of the filter of the equalizer of Figure 1;

Figure 3 is a block diagram of a preferred embodiment of a data reproduction apparatus according to the present invention;

Figure 4 is a flowchart illustrating an error detection method using the positive and negative middle levels of the output value of the equalizer when a PR (a,b,a) type Viterbi detector is adopted;

Figure 5 is a flowchart illustrating an error detection method using the positive and negative maximum levels of the output value of the equalizer when a PR (a,b,a) or PR (a,b,b,a) type Viterbi detector is adopted;

Figure 6 is a flowchart illustrating an error detection method using the zero level of the output value of the equalizer when a PR (a,b,b,a) type Viterbi detector is adopted;

Figure 7 is a flowchart illustrating an error detection method using the positive and negative middle levels of the output value of the equalizer when a PR (a,b,b,a) type Viterbi detector is adopted;

Figure 8 is a diagram illustrating a channel adaptation model which is applied in calculating coefficients to be stored in the coefficient bank 112 of Figure 3;

Figure 9 illustrates variations in the filter tap coefficients of the equalizer when defocusing occurs;

Figure 10 illustrates variations in the filter tap coefficients of the equalizer when tangential tilting occurs;

Figure 11 illustrates an example of the structure of the equalizer applied to the data reproduction apparatus according to the present invention;

Figures 12A through 12C illustrate the variation in the level error with respect to tangential tilt angle when filter coefficients are adapted according to the present invention, and when they are not adapted;

Figure 13 illustrates the effect of using adapted filter coefficients when tangential tilting by 0.5° occurs;

Figure 14 illustrates the effect of using adapted filter coefficients when a defocusing of 60 μm occurs;

Figure 15 is a block diagram of another embodiment of the data reproduction apparatus according to the present invention;

Figure 16 is a block diagram of still another embodiment of the data reproduction apparatus according to the present invention, which is capable of detecting defocusing/tangential tilting;

Figures 17A through 17C illustrate variations in filter tap coefficients of the equalizer with respect to the degree of defocusing;

Figures 18A through 18C illustrate variations in filter tap coefficients of the equalizer with respect to tangential tilt angle; and

Figure 19 is a flowchart illustrating the detection of defocusing or tilting by the defocus/tilt detector shown in Figure 16.

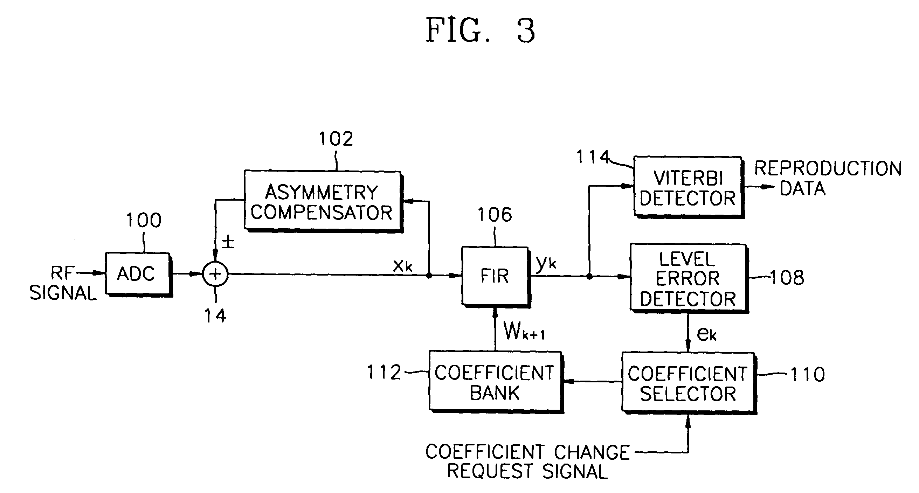

A preferred embodiment of a data reproduction apparatus according to the present invention is shown in Figure 3. In Figure 3, an analog-to-digital converter (ADC) 100, an asymmetry compensator 102, an adder 104, an equalizer 106 and a Viterbi detector 114 are the same as those shown in Figure 1. Thus, a description of the operation of these elements won't be repeated here. The Viterbi detector 114 is a data detector based on partial response maximum likelihood (PRML).

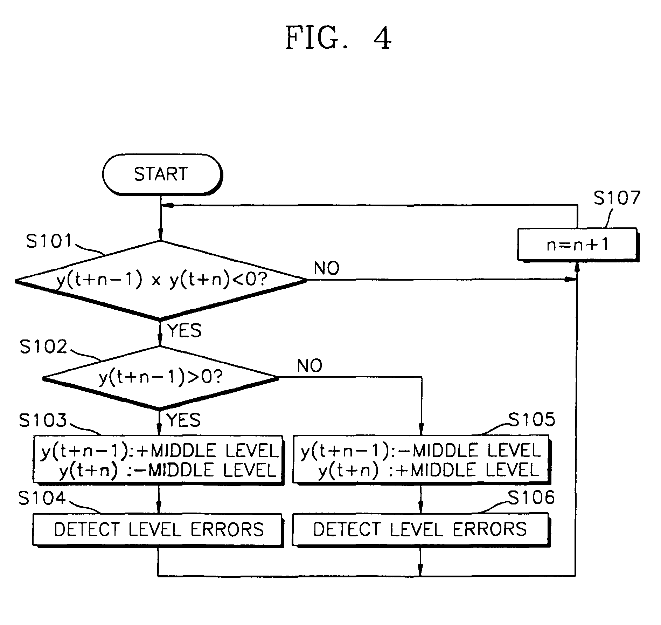

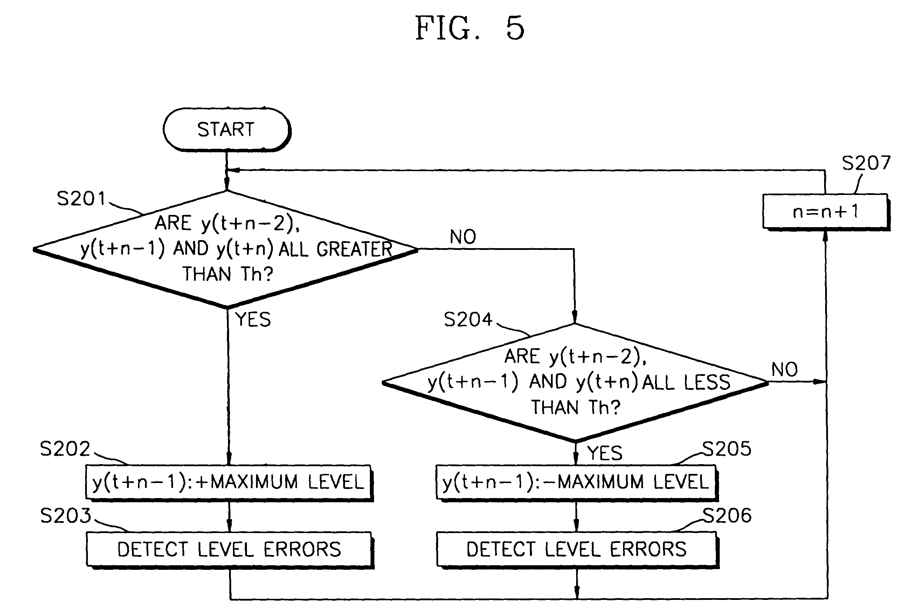

For example, if the Viterbi detector 114 is a PR(a,b,a) type, a level error detector 108 has predetermined reference values for positive and negative middle and maximum levels. The level error detector 108 detects positive and negative middle and maximum levels from an input signal $y_k$ by detection methods, which will be described with reference to Figures 4 and 5, and outputs a level error $e_k$ for each detected level with respect to the corresponding reference values. If the Viterbi decoder 114 is a PR(a,b,b,a) type, the level error detector 108 has predetermined reference values for positive and negative middle and maximum levels as well as zero level. The level error detector 108 detects those levels from the input signal $y_k$ by detection methods, which will be described with reference to Figures 5, 6 and 7, and outputs a level error $e_k$ for each detected level with respect to the corresponding reference values. A coefficient bank 112, which stores a plurality of coefficient values for the equalizer 106, outputs a coefficient value $W_{k+1}$ according to selection by a coefficient selector 110, as a filter tap coefficient value for the equalizer 106.

When a coefficient change request signal is input from a controller (not shown) or a servo unit (not shown), the coefficient selector 110 selects coefficients stored in the coefficient bank 112, and changes the tap filter coefficients of the equalizer 106. The coefficient selector 110 checks the level error $e_k$ output from the level error detector 108 and sets the coefficient with the minimum level error as the final filter tap coefficient for the equalizer 106.

Hereinafter, a method for detecting the level error $e_k$ by the level error detector 108 with various levels extracted from the input signal $y_k$ will be described. Figure 4 is a flowchart illustrating a preferred embodiment of an error detection method with the positive and negative middle levels extracted from the output signal $y_k$ of the equalizer 106 when a PR(a,b,a) type Viterbi decoder is adopted.

In step S101, it is determined whether the product of two successive sampling data y(t+n-1) and y(t+n) is less than 0. If yes, it is determined which one of the two sampling data, for example, y(t+n-1), is greater than 0 (step S102). One of the sampling data, which is greater than 0, is determined to be a positive middle level, and the other sampling data which is less than 0 is determined to be a negative middle level. That is, if it is determined in step S103 that y(t+n-1) is greater than 0, y(t+n-1) is determined as the positive middle level, and y(t+n) is determined as the negative middle level (step S103). Next, a level error corresponding to a difference between the positive middle level, the value of data y(t+n-1), and a corresponding reference value, and a level error corresponding to a difference between a corresponding reference value and the negative middle level, the value of data y(t+n), are detected (step S104).

If it is determined in step S102 that the sampling data y(t+n-1) is less than 0, y(t+n-1) is determined to be a negative middle level and y(t+n) is determined to be a positive middle level (step S105). Next, in step S106, a level error corresponding to a difference between the negative middle level, the value of data y(t+n) and a corresponding reference value, and a level error corresponding to a difference between a corresponding reference value and the positive middle level, the value of data y(t+n-1), are detected. if the product of the sampling data y(t+n-1) and y(t+n) is not less than 0, or after steps S104 and S106 are completed, steps S101 through S106 are reiterated to determine positive and negative middle levels for the next sample (step S107).

Figure 5 is a flowchart illustrating a preferred embodiment of an error detection method using the positive and negative maximum levels extracted from the output signal $y_k$ of the equalizer 106 when a PR(a,b,a) or PR(a,b,b,a) type Viterbi decoder is adopted.

It is determined whether all of three successive sampling data y(t+n-2), y(t+n-1) and y(t+n) are greater than a threshold value Th (step S201). If yes, the middle sampling data y(t+n-1) is determined to be a positive maximum level (step S202). Next, a level error corresponding to a difference between the positive maximum level, the value of y(t+n-1), and a corresponding reference value is detected (step S203).

If, in step S201, any of the sampling data y(t+n-2), y(t+n-1) and y(t+n) is less than the threshold value Th, it is determined whether all of the three successive data y(t+n-2), y(t+n-1) and y(t+n) is less than the threshold value Th (step S204). If yes, the middle sampling data y(t+n-1) is determined to be a negative maximum level (step S205). Next, a level error corresponding to a difference between the negative maximum level, the value of y(t+n-1), and a corresponding reference value is detected (step S206).

If, in step S204, at least one of the successive sampling data y(t+n-2), y(t+n-1) and y(t+n) is not less than the threshold value Th, or if steps S203 and S206 are completed, steps S201 through S206 are reiterated to determine positive and negative maximum levels for the next sample (step S207).

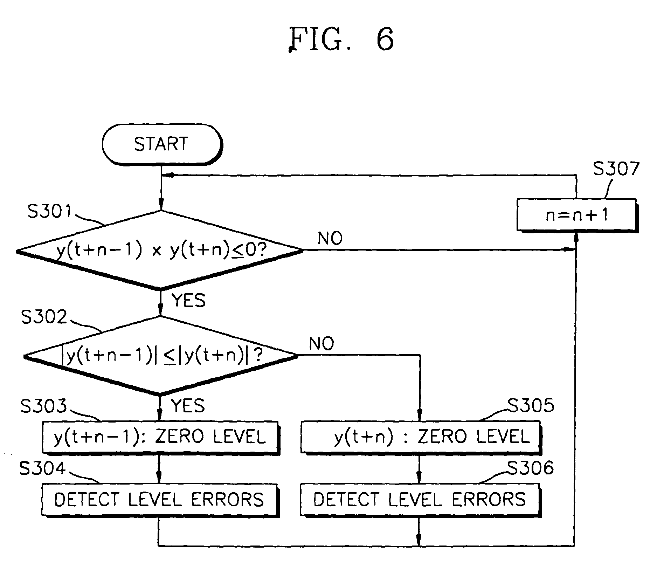

Figure 6 is a flowchart illustrating a preferred embodiment of an error detection method using the zero level extracted from the output signal $y_k$ of the equalizer 106 when a PR(a,b,b,a) type Viterbi decoder is adopted.

First, it is determined whether the product of the successive sampling data y(t+n-1) and y(t+n) is less than or equal to 0 (step S301). Then, the absolute values of the sampling data y(t+n-1) and y(t+n) are compared (step S302). If the absolute value of the leading sampling data y(t+n-1) is less than or equal to the absolute value of the other sampling data y(t+n), the sampling data y(t+n-1) is determined to be the zero level (step S303). Then, a level error corresponding to the difference between the data value of y(t+n-1) and a reference value is detected (step S304). If it is determined in step S302 that the absolute value of the sampling data y(t+n) is smaller than that of the leading sampling data y(t+n-1), the sampling data y(t+n) is determined to be the zero level (step S305). Then, a level error corresponding to the difference between the data value of the sampling data y(t+n) and the reference value is detected (step S306). If the product of the two sampling data y(t+n-1) and y(t+n) is greater than 0, or if the step S304 or S306 is completed, steps S301 through S306 are reiterated to detect the zero level for the next sample (step S307).

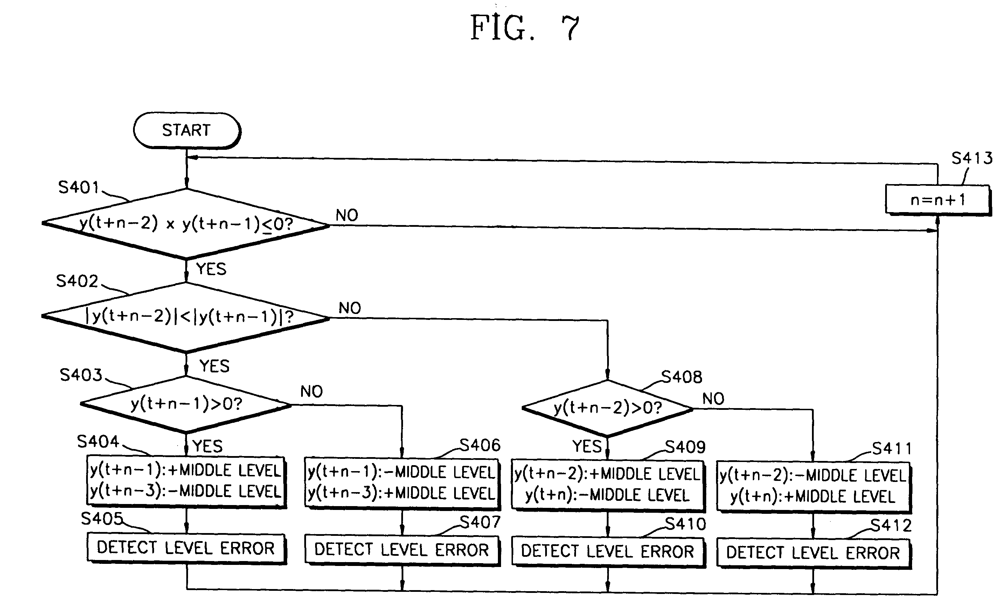

Figure 7 is a flowchart illustrating a preferred embodiment of an error detection method using the positive and negative minimum levels extracted from the output signal $y_k$ of the equalizer 106 when a PR(a,b,b,a) type Viterbi decoder is adopted.

It is determined whether the product of the two successive data y(t+n-2) and y(t+n-1) is less than or equal to 0 (step S401). If yes, the absolute values of the sampling data y(t+n-2) and y(t+n-1) are compared (step S402). Then, it is individually determined whether the data value of y(t+n-1) is greater than 0 and whether y(t+n-2) is greater than 0. If the sampling data is greater than 0, the sampling data is determined to be the positive middle level. If the sampling data is less than 0, the sampling data is determined to be the negative middle level.

In particular, if the absolute value of the following sampling data y(t+n-1) is greater than the leading sampling data y(t+n-2) (step S402), and if the data value of the sampling data y(t+n-1) is greater than 0 (step S403), the sampling data y(t+n-1) is determined to be a positive middle level, and the preceding sampling data y(t+n-3) of the sampling data y(t+n-2) is determined to be a negative middle level (step S404). Then, a level error corresponding to the difference between the data value of the positive middle level, y(t+n-1), and a reference value, and a level error corresponding to the difference between the data value of the negative middle level, y(t+n-3), and a reference value, are detected (step S405).

If it is determined in step S403 that the data value of the sampling data y(t+n-1) is not greater than 0, the sampling data y(t+n-1) is determined to be a negative middle level, and the preceding sampling data y(t+n-3) of the sampling data y(t+n-2) is determined to be a positive middle level (step S406). Then, level errors for the negative and positive middle levels y(t+n-1) and y(t+n-3), which correspond to differences between the negative and positive middle levels and corresponding reference values, are detected (step S407).

If it is determined in step S402 that the absolute value of the leading sampling data y(t+n-2) is greater than or equal to that of the sampling data y(t+n-1), and if the data value of the sampling data y(t+n-2) is greater than 0 (step S408), the sampling data y(t+n-2) is determined to be a positive middle level, and the sampling data y(t+n) following the sampling data y(t+n-1) is determined to be a negative middle level (step S409). Then, level errors for the positive and negative middle levels, y(t+n-2) and y(t+n), which correspond to differences between the data values of the sampling data y(t+n-2) and y(t+n), and corresponding reference values, are detected (step S410).

If it is determined in step 408 that the data value of the sampling data y(t+n-2) is not greater than 0, the sampling data y(t+n-2) is determined to be a negative middle level, and the sampling data y(t+n) following the sampling data y(t+n-1) is determined to be a positive middle level (step S411). Then, level errors for the negative and positive middle levels, y(t+n-2) and y(t+n), which correspond to differences between the data values of the sampling data y(t+n-2) and y(t+n), and corresponding reference values, are detected (step S412).

If it is determined in step S401 that the product of the two sampling data y(t+n-2) and y(t+n-1) is greater than 0, or if step S405, S407, S410 or S412 is completed, steps 401 through 412 are reiterated to detect the positive and negative middle levels for the next sample (step S413).

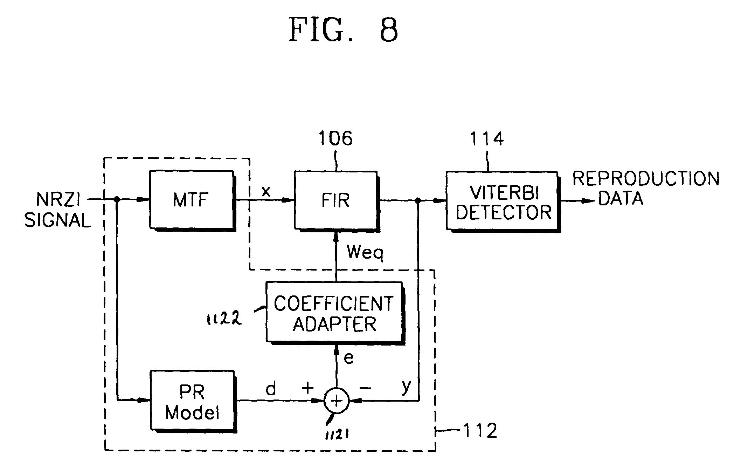

Figure 8 is a diagram illustrating a channel adaptation model which is applied in calculating coefficients to be stored in the coefficient bank 112 of Figure 3.

Assuming that a channel model when defocusing or tilting occurs is a modulation transfer function (MTF) channel, a radio frequency (RF) signal produced through the channel is $x$, and the output from the equalizer 106 is $y$, the coefficient adapter of the coefficient bank 112, as shown in Figure 8, outputs a coefficient Weq which enables a level error $e$ between an initial non-return zero inversion (NRZI) signal passed through a PR model, for example, PR(a,b,a) or PR(a,b,b,a), not through the MTF channel, to converge to zero. Here, the PR model refers to the type of the Viterbi decoder 114 used. The constituent blocks of the coefficient bank 112 shown in Figure 8 are implemented by software, not by hardware.

Such extraction of the coefficient Weq may be performed for limited cases, for example, when the degree of defocusing is 15 μm, 30 μm, 45 μm or 60 μm, or when a tangential tilt angle is 0.125°, 0.25°, 0.375 ° or 0.5°, and then the obtained coefficients may be stored in the coefficient bank 112.

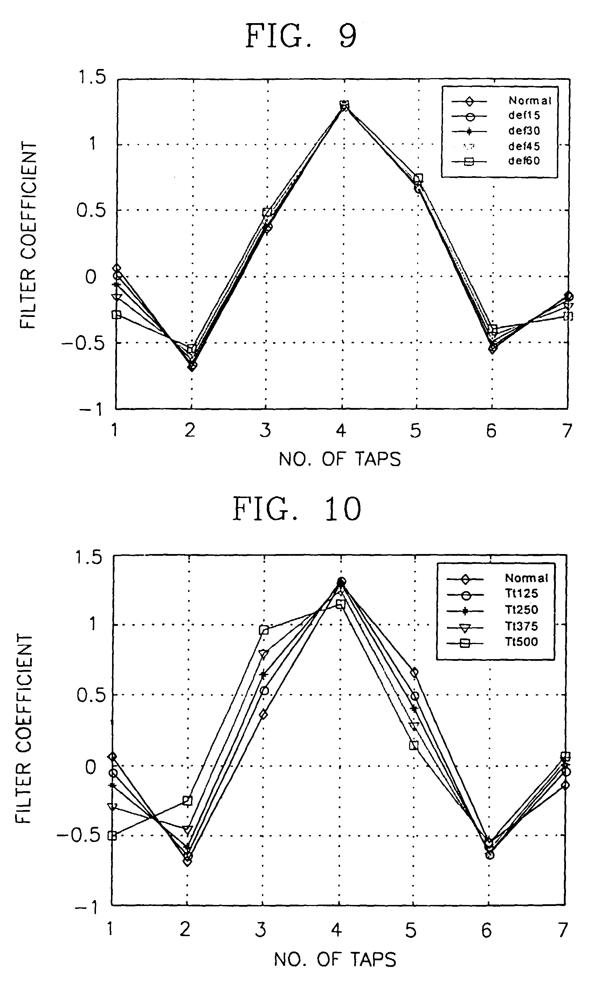

When the degree of defocusing is varied at 15 μm, 30 μm, 45 μm and 60 μm, the tap coefficients of the equalizer (7-tap) 106, which were obtained by applying the method illustrated in Figure 8, are shown versus the number of taps in Figure 9. When the tangential tilt angle is 0.125°, 0.25°, 0.375 ° and 0.5°, the tap coefficients of the equalizer (7-tap)106, which were obtained by the method of Figure 8, are shown versus the number of taps in Figure 10.

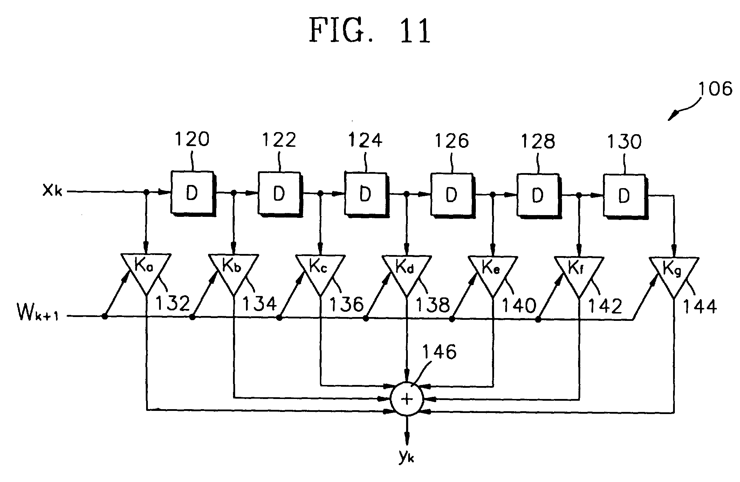

The structure of the equalizer, which is constructed of a 7-tap FIR filter, is shown in Figure 11. The 7-tap FIR filter is characterized in that each tap coefficient can be separately and asymmetrically set around the center tap $K_d$. In Figure 11, $x_k$ indicates the input data of the equalizer 106, $y_k$ indicates the output data of the equalizer 106, and $W_{k+1}$ indicates the coefficients of the equalizer 106 after adaptation. Reference numerals 120, 122, 124, 126, 128 and 130 represent delays, reference numerals 132, 134, 136, 138, 140, 142 and 144 represent multipliers, and reference numeral 146 represents an adder.

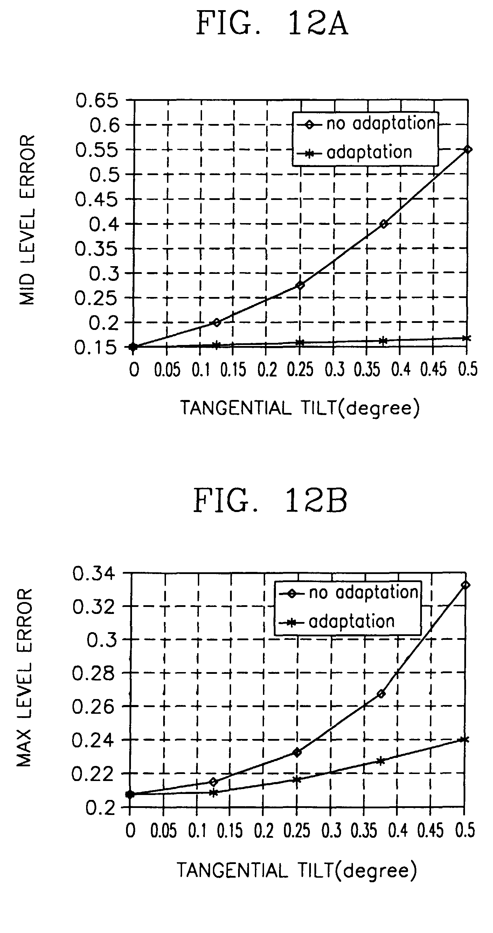

Figures 12A through 12C comparatively show level errors with respect to variations in tangential tilt angle when the tap coefficients of the equalizer are fixed, and adapted as shown in Figure 10. Here, a PR (1,2,1) type Viterbi detector was used. For the case of using adapted coefficients, although the tangential tilt angle is increased up to 0.5°, the variation in level error is much less than when fixed coefficients are used. Also, the difference in the amplitudes of level errors when using fixed and adapted coefficients, respectively, increases at larger tangential tilt angles.

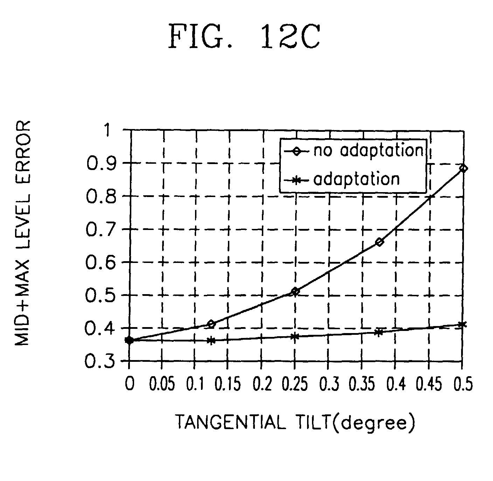

In particular, Figure 12A shows the variation in the middle level error with respect to tangential tilt angle when the tap coefficients of the equalizer are adapted and fixed. Figure 12B shows the variation in the maximum level error with respect to tangential tilt angle when the tap coefficients of the equalizer are adapted and fixed. Figure 12C shows the variation in the sum of the middle and maximum level errors with respect to tangential tilt angle when the tap coefficients of the equalizer are adapted and fixed.

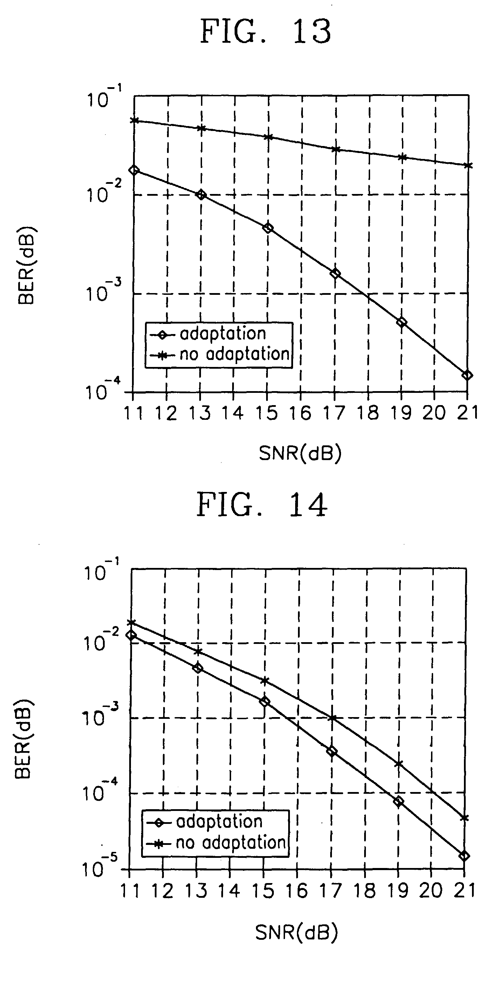

Figures 13 and 14 show that when a tangential tilt angle of 0.5° or a degree of defocusing of 60 μm

occurs, the bit error rate (BER) of a reproduction signal output from the Viterbi decoder can be reduced more by using adapted coefficients than by using fixed coefficients.

In particular, Figure 13 illustrates the effect of using adapted coefficients on the error rate of the reproduction signal, compared to the case of using fixed coefficients, when a tangential tilt of 0.5° occurs. Figure 14 illustrates the effect of using adapted coefficients on the error rate of the reproduction signal, compared to the case of using fixed coefficients, when defocusing of 60 μm occurs.

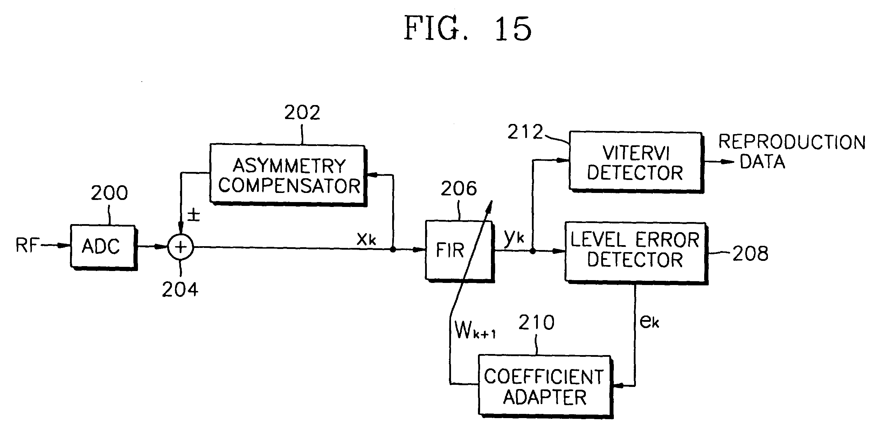

Another embodiment of the data reproduction apparatus according to the present invention is shown in Figure 15. As shown in Figure 15, the data reproduction apparatus includes an ADC 200, an asymmetry compensator 202, an adder 204, an equalizer 206 and a Viterbi detector 212. The elements are the same as these of Figure 3, and thus a description of their structure won't be repeated here.

Assuming that a target level value is $t_k$, the error value $e_k$ output from the level error detector 208 is obtained by subtracting the level value $y_k$ detected as shown in Figures 4 through 7 from the target level value $t_k$, which is expressed by $e_k = t_k - y_k$. As shown in Figure 11, the filter coefficients of the equalizer 206 are obtained by adaptation in the coefficient adapter 210, using formula 1 to minimize the error value $e_k$.

$$W_{k+1} = W_k + 2\mu \cdot e_k \cdot x_k \qquad (1)$$

where $W_{k+1}$ indicates a filter coefficient of the equalizer after adaptation, $W_k$ indicates a filter coefficient of the equalizer before adaptation, $\mu$ is a coefficient relating to equalization rate (0.001 for the present embodiment), $e_k$ indicates a level error, and $x_k$ indicates an RF signal after asymmetry correction.

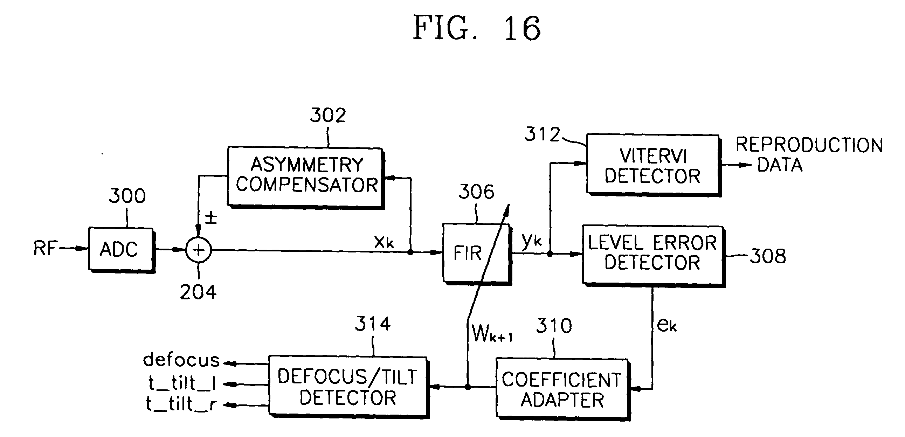

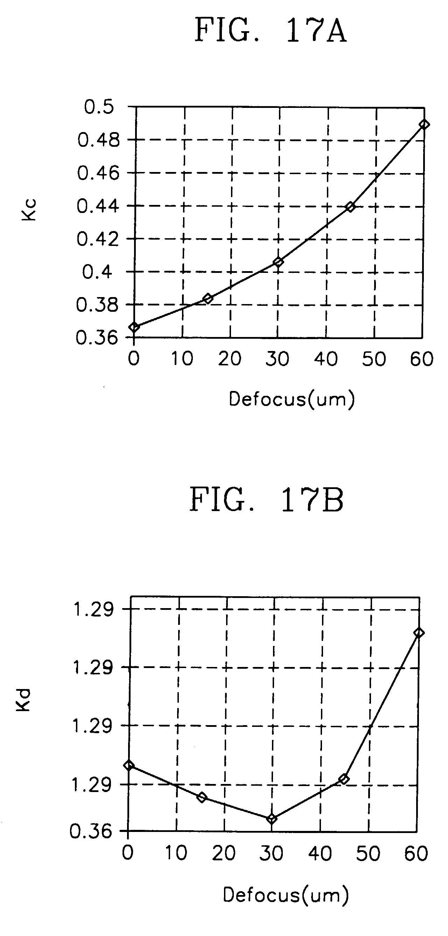

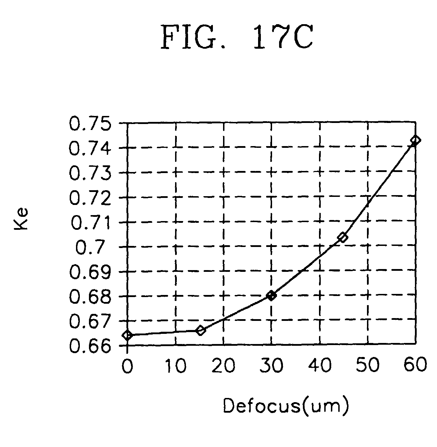

Figure 16 illustrates still another embodiment of a data reproduction apparatus according to the present invention, further having a defocus/tilt detection function. The only difference between the structure of this embodiment and the structure shown in Figure 15 is that the defocus/tilt detector 314 is further included. Thus, only the operation of the defocus/tilt detector 314 will be described with reference to the tap coefficient variation curves shown in Figures 17A through 17C and Figures 18A through 18C, and Figure 19.

When defocusing occurs, as shown in Figures 17A through 17C, the center tap coefficient $K_d$ of the equalizer 306 almost does not change, while both the tap coefficients $K_c$ and $K_e$, which are on the left and right of the center tap coefficient $K_d$, respectively, tend to increase. Figures 17A through 17C illustrate variations of the left tap coefficient $K_c$, the center tap coefficient $K_d$, and the right tap coefficient $K_e$, respectively, according to the degree of defocusing. Thus, when it is detected that the left tap coefficient $K_c$ and the right tap coefficient $K_e$ increase, the defocus/tilt detector 314 outputs a defocus signal.

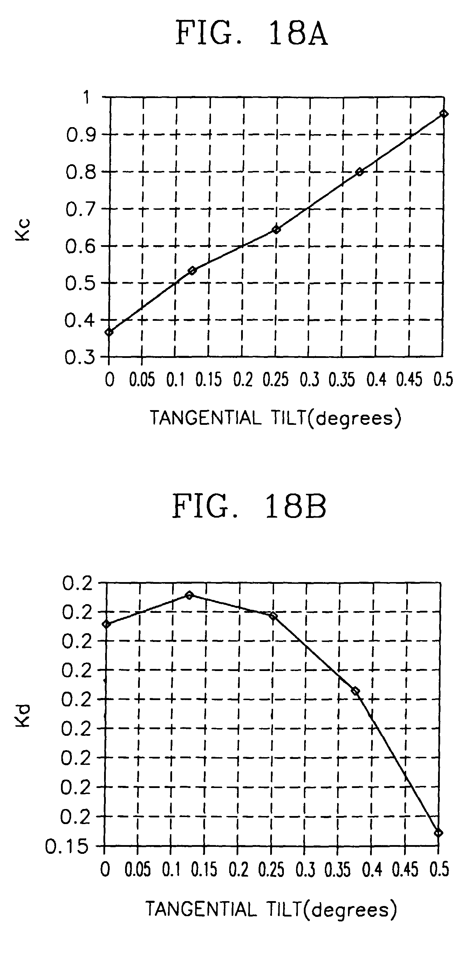

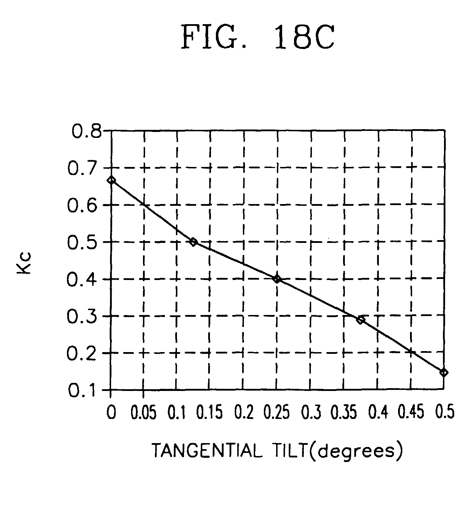

Meanwhile, when tangential tilting occurs, the filter coefficients of the equalizer 306 vary as shown in Figures 18A through 18C. The left and right tap coefficients $K_c$ and $K_e$ show opposite tendencies around the central tap coefficient $K_d$, i.e., if one of the left and right tap coefficients $K_c$ and $K_e$ increases, the other tap coefficient decreases. Thus, according to which tap coefficient increases or decreases, the direction of the tangential tilting can be inferred. Figures 18A through 18C illustrate the variation of the left tap coefficient $K_c$, the center tap coefficient $K_d$, and the right tap coefficient $K_e$, respectively, according to the tangential tilt angle. Thus, by detecting which tap coefficient, $K_c$ or $K_e$, around the center tap coefficient $K_d$ increases or decreases, the defocus/tilt detector 314 outputs a tangential tilt signal t_tilt_r or t_tilt_l. Here, the signal t_tilt_r indicates that a recording medium is tilted in the moving direction of a pickup, and the signal t_tilt_r indicates that the recording medium is tilted in the opposite direction.

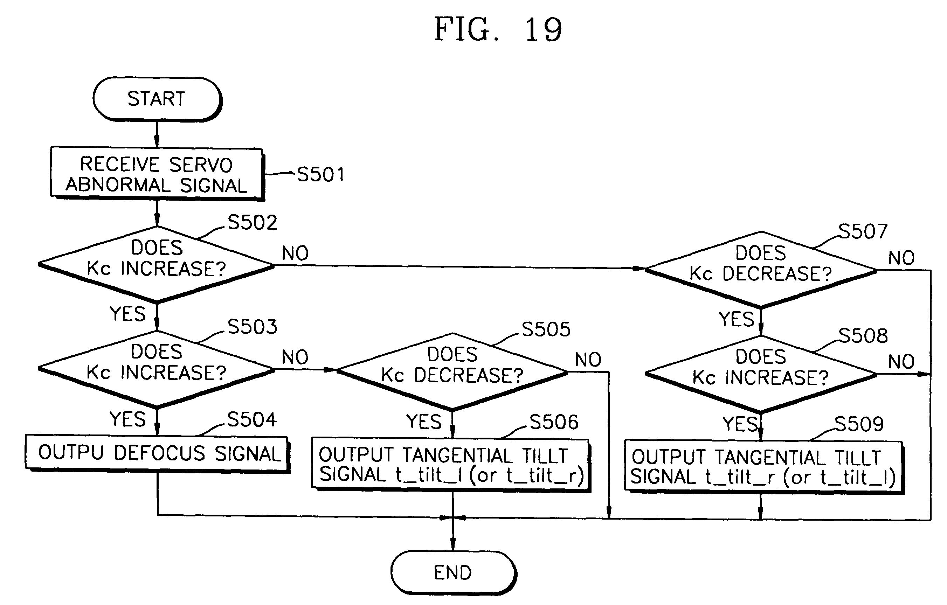

Figure 19 is a flowchart illustrating the detection of defocusing or tilting by the defocus/tilt detector shown in Figure 16. Referring to Figure 19, the operation of the defocus/tilt detector begins with reception of a servo abnormal signal (S501). Although not illustrated in Figure 19, the servo abnormal signal can be detected directly from a servo unit or a pickup unit by a system microcomputer.

Next, it is determined whether the filter coefficient $K_c$ on the left of the center tap coefficient $K_d$ increases (S502). If the left filter coefficient $K_c$ increases, it is determined whether the filter coefficient $K_e$ on the right of the center tap coefficient $K_d$ increases (S503). If both the left and right filter coefficients $K_c$ and $K_e$ increase, a defocus signal is output (S504). If it is determined in step S503 that the filter coefficient $K_e$ does not increase, it is determined whether the filter coefficient $K_e$ decreases (S505). If the filter coefficient $K_c$ increases and the filter coefficient $K_e$ decreases, a tangential tilt signal t_tilt_l or t_tilt_r is output (S506).

If it is determined in S502 that the filter coefficient $K_c$ does not increase, it is determined whether the filter coefficient $K_c$ decreases (S507). If the filter coefficient $K_c$ decreases, it is determined whether the filter coefficient $K_e$ increases (S508). If the filter coefficient $K_c$ decreases and the filter coefficient $K_e$ increases, a tangential tilt signal t_tilt_r or t_tilt_l is also output (S509).

As previously mentioned, the filter coefficients of the equalizer, which is connected in front of the Viterbi decoder, are selected such that the level error to be input to the Viterbi detector is minimized, thereby improving the reproduction performance.

The level error is detected by adapting the filter coefficients of the equalizer according to the PR type of the Viterbi decoder, so that the level error is minimized with enhanced reproduction characteristics.

In addition, the servo status can be inferred from variations in the filter coefficients of the equalizer. In other words, whether defocusing or tangential tilting occurs, and the direction of the tangential tilting can be detected. Thus, when jittering of data occurs due to defocusing or tilting, the error rate of data can be improved by adjusting the filter coefficients of the equalizer.

While this invention has been particularly shown and described with reference to preferred embodiments thereof, it will be understood by those skilled in the art that various changes in form and details may be made thereto without departing from the spirit and scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extend to any novel one, or any novel combination, of the features disclosed in this specification (including any accompanying claims, abstract and drawings), or to any novel one, or any novel combination, of the steps of any method or process so disclosed.

**Claims**

1. A data reproduction apparatus including a data detector for detecting data based on partial response maximum likelihood (PRML), the apparatus comprising:

   an equalizer comprising a digital filter (106);

   a level error detector (108) for extracting a level of the output value of the equalizer based on a reference level set in the data detector, and detecting a level error between the level of the output value and a predetermined reference value;

   a coefficient bank (112) for storing filter coefficients of the equalizer; and

a coefficient selector (110) for selecting the filter coefficients of the equalizer from the coefficient bank such that the level error is minimized.

**2.** The data reproduction apparatus of claim 1, wherein the error detector predetermines at least one reference value corresponding to zero level, positive and negative middle levels, and positive and negative maximum levels, which are classified depending on the partial response (PR) type of the data detector and detects the levels from the output value of the equalizer, and outputs the level error corresponding to differences between the detected levels and corresponding reference values.

**3.** The data reproduction apparatus of claim 1 or 2, wherein the error detector determines whether or not the product of two successive sampling data output from the equalizer is less than 0, determines which one of the sampling data is greater than 0 if the product of the two successive sampling data is less than 0, determines the sampling data greater than 0 as the positive middle level, and the sampling data less than 0 as the negative middle level, and detects level errors corresponding to the differences between the values of the sampling data determined as the positive and negative middle levels, and corresponding reference values.

**4.** The data reproduction apparatus of claim 1,2 or 3, wherein the error detector determines whether or not all three successive sampling data output from the equalizer are greater than a predetermined threshold value, determines the middle sampling data as the positive maximum level if all of the three successive sampling data are greater than the predetermined threshold value, and determines the middle sampling data as the negative maximum level if all of the three successive sampling data are less than the predetermined threshold value, and detects level errors corresponding to the differences between the values of the sampling data determined as the positive and negative maximum levels, and corresponding reference values.

**5.** The data reproduction apparatus of any preceding claim, wherein the error detector determines whether or not the product of two successive sampling data output from the equalizer is less than or equal to 0, and determines the sampling data whose absolute value is less than the absolute value of the other sampling data as the zero level, and detects the difference between the value of the sampling data determined as the zero level and a corresponding reference value.

**6.** The data reproduction apparatus of any preceding claim, wherein the error detector determines whether the product of two successive sampling data output from the equalizer is less than or equal to 0, compares the absolute values of the two successive data if the product of two successive sampling data output from the equalizer is less than or equal to 0, determines the latter of the two successive sampling data, and the sampling data preceding the two successive sampling data to be the positive and negative middle levels, respectively, if the absolute value of the latter of the two successive sampling data is greater than that of the other sampling data, determines the sampling data preceding the two successive sampling data, and the sampling data following the two successive sampling data to be the positive and negative middle levels, respectively, if the absolute value of the former of the two successive sampling data is and greater than or equal to the other sampling data, and detects level errors corresponding to the differences between the values of the sampling data determined as the negative and positive middle levels, arid corresponding reference values.

**7.** The data reproduction apparatus of any preceding claim, wherein the coefficient bank (112) stores the filter coefficients of the equalizer, which are adapted according to the servo status and the degree of defocusing and tangential tilting.

**8.** The data reproduction apparatus of any preceding claim, wherein the coefficient selector (110) selects coefficients stored in the coefficient bank according to a coefficient change request signal input from the outside to replace the filter coefficients of the equalizer with the selected coefficients, checks the level error output from the level error detector, and determines the coefficients which minimize the level error to be the final filter coefficients of the equalizer.

**9.** A data reproduction apparatus including a data detector for detecting data based on partial response maximum likelihood (PRML), the apparatus comprising:

an equalizer (106) comprising a digital filter;

a level error detector (1121) for extracting a level of the output value of the equalizer (106) based on a reference level set in the data detector, and detecting a level error between the level of the output value and a predetermined reference value; and

a coefficient adapter (1122) for adapting filter coefficients of the equalizer such that a difference between the level error and a target level error is minimized.

10. The data reproduction apparatus of claim 9, wherein the error detector predetermines at least one reference value corresponding to zero level, positive and negative middle levels, and positive and negative maximum levels, which are classified depending on the partial response (PR) type of the data detector and detects the levels from the output value of the equalizer, and outputs the level error corresponding to differences between the detected levels and corresponding reference values.

11. The data reproduction apparatus of claim 9 or 10, wherein the error detector determines whether or not the product of two successive sampling data output from the equalizer is less than 0, determines which one of the sampling data is greater than 0 if the product of the two successive sampling data is less than 0, determines the sampling data greater than 0 as the positive middle level, and the sampling data less than 0 as the negative middle level, and detects level errors corresponding to the differences between the values of the sampling data determined as the positive and negative middle levels, and corresponding reference values.

12. The data reproduction apparatus of claim 9, 10 or 11, wherein the error detector determines whether or not all three successive sampling data output from the equalizer are greater than a predetermined threshold value, determines the middle sampling data as the positive maximum level if all of the three successive sampling data are greater than the predetermined threshold value, and determines the middle sampling data as the negative maximum level if all of the three successive sampling data are less than the predetermined threshold value, and detects level errors corresponding to the differences between the values of the sampling data determined as the positive and negative maximum levels, and corresponding reference values.

13. The data reproduction apparatus of claim 9, 10, 11 or 12, wherein the error detector determines whether or not the product of two successive sampling data output from the equalizer is less than or equal to 0, and determines the sampling data whose absolute value is less than the absolute value of the other sampling data as the zero level, and detects the difference between the value of the sampling data determined as the zero level and a corresponding reference value.

14. The data reproduction apparatus of claim 9, 10, 11, 12 or 13, wherein the error detector determines whether the product of two successive sampling data output from the equalizer is less than or equal to 0, compares the absolute values of the two successive data if the product of two successive sampling data output from the equalizer is less than or equal to 0, determines the latter of the two successive sampling data, and the sampling data preceding the two successive sampling data to be the positive and negative middle levels, respectively, if the absolute value of the latter of the two successive sampling data is greater than that of the other sampling data, determines the sampling data preceding the two successive sampling data, and the sampling data following the two successive sampling data to be the positive and negative middle levels, respectively, if the absolute value of the former of the two successive sampling data is and greater than or equal to the other sampling data, and detects level errors corresponding to the differences between the values of the sampling data determined as the negative and positive middle levels, and corresponding reference values.

15. The data reproduction apparatus of any of claims 9 to 14, further comprising a defocus/tilt detector for detecting the servo status by monitoring variations of the adaptive filter coefficients of the equalizer.

16. The data reproduction apparatus of claim 15, wherein the defocus/tilt detector determines a state where both side tap coefficients around the central tap coefficient of the equalizer increase to be a state of defocus, and outputs a defocus signal.

17. The data reproduction apparatus of claim 15 or 16, wherein the defocus/tilt detector determines a state where one side tap coefficient with respect to the central tap coefficient of the equalizer increases while the opposite side tap coefficient decreases to be a state of tangential tilting, and outputs a tangential tilt signal.

18. The data reproduction apparatus of claim 17, wherein the defocus/tilt detector determines the direction of the tangential tilting according to which side tap coefficient increases or decreases with respect to the central tap coefficient.

19. A data reproduction method capable of improving the performance of a data detector for detecting data based on partial response maximum likelihood (PRML) by adjusting filter coefficients of an equalizer comprising a digital filter, connected before the data detector, the method comprising the steps of:

(a) extracting a level of the output data of the equalizer based on a reference level set in the data detector, and detecting a level error between the level of the output data and a predetermined reference value; and

(b) adjusting the filter coefficients of the equalizer such that the level error is minimized.

20. The data reproduction method of claim 19, wherein in step (a), at least one reference value corresponding to zero level, positive and negative middle levels, or positive and negative maximum levels, which are classified depending on the partial response (PR) type of the data detector is predetermined, a level of the output value of the equalizer is detected based on the classified levels, and the level error is detected corresponding to differences between the detected levels and corresponding reference values.

21. The data reproduction method of claim 19, wherein step (a) comprises:

(a1) determining whether or not the product of two successive sampling data output from the equalizer is less than 0, determining which one of the sampling data is greater than 0 if the product of the two successive sampling data is less than 0, determining the sampling data greater than 0 as the positive middle level, and the sampling data less than 0 as the negative middle level; and

(a2) detecting level errors corresponding to the differences between the values of the sampling data determined as the positive and negative middle levels, and corresponding reference values.

22. The data reproduction method of claim 19, wherein step (a) comprises:

(a1) determining whether or not all three successive sampling data output from the equalizer are greater than a predetermined threshold value, determining the middle sampling data as the positive maximum level if all of the three successive sampling data are greater than the predetermined threshold value, and the middle sampling data as the negative maximum level if all of the three successive sampling data are less than the predetermined threshold value; and

(b) detecting level errors corresponding to the differences between the values of the sampling data determined as the positive and negative maximum levels, and corresponding reference values.

23. The data reproduction method of claim 20, wherein step (a) comprises:

(a1) determining whether or not the product of two successive sampling data output from the equalizer is less than or equal to 0, and determining the sampling data whose absolute value is less than the absolute value of the other sampling data as the zero level; and

(a2) detecting the difference between the value of the sampling data determined as the zero level and a corresponding reference value.

24. The data reproduction method of claim 20, wherein step (a) comprises:

(a1) determining whether or not the product of two successive sampling data output from the equalizer is less than or equal to 0, and comparing the absolute values of the two successive data;

(a2) determining the latter of the two successive sampling data, and the sampling data preceding the two successive sampling data to be the positive and negative middle levels, respectively, if the absolute value of the latter of the two successive sampling data is greater than that of the other sampling data;

(a3) detecting level errors corresponding to the differences between the values of the sampling data determined as the negative and positive middle levels in step (a2), and corresponding reference values;

(a4) determining the sampling data preceding the two sampling data, and the latter of the two successive sampling data to be the positive and negative middle levels, respectively, if the absolute value of the former of the two successive sampling data is greater than or equal to the other sampling data; and

(a5) detecting level errors corresponding to the differences between the values of the sampling data determined as the negative and positive middle levels in step (a4), and corresponding reference values.

25. The data reproduction method of claim 19, wherein in step (b) the filter coefficients of the equalizer are adapted according to the servo status and the degree of defocusing and tangential tilting.

26. The data reproduction method of claim 19, wherein in step (b) the filter coefficients of the equalizer are changed according to a coefficient change request signal input from the outside, and the level error is continuously checked to determine the coefficients which minimize the level error as the final filter coefficients of the equalizer.

27. The data reproduction method of claim 19, wherein in step (b) the filter coefficients of the equalizer are adapted such that a difference between the level error and a target level error is minimized.

28. The data reproduction method of claim 27, further comprising (c) monitoring the adaptive filter coefficients of the equalizer and determining the servo status according to the variations of the adaptive filter coefficients.

29. The data reproduction method of claim 28, wherein in step (c) when both side tap coefficients around the central tap coefficient of the equalizer increase, the state is determined to be a state of defocus.

30. The data reproduction method of claim 28, wherein in step (c) when one side tap coefficient with respect to the central tap coefficient increases while the opposite side tap coefficient decreases, the state is determined to be a state of tangential tilting.

31. The data reproduction method of claim 30, wherein in step (c) the direction of the tangential tilting is detecting according to which side tap coefficient increases or decreases.

# FIG. 1 (PRIOR ART)

EP 1 098 313 A2

# FIG. 2

# FIG. 3

EP 1 098 313 A2

# FIG. 4

```
                    ┌──────────┐
                    │  START   │
                    └────┬─────┘                                    ┌─ S107
                         │                            ┌──────────────────┐
  S101                   │                            │     n=n+1        │
         ◇──────────────────────────◇    NO          └──────────────────┘
         │  y(t+n−1) x y(t+n)<0?     │────────────────────────┐         │
         ◇──────────────────────────◇                         │         │
                         │ YES                                 │         │
  S102                   │                                     │         │
         ◇──────────────────────◇    NO                        │         │
         │   y(t+n−1)>0?         │──────────────┐              │         │
         ◇──────────────────────◇               │              │         │
                         │ YES                  │              │         │
  S103 ┌────────────────────────────┐   S105 ┌────────────────────────────┐
       │ y(t+n−1):+MIDDLE LEVEL      │        │ y(t+n−1):−MIDDLE LEVEL      │
       │ y(t+n) :−MIDDLE LEVEL       │        │ y(t+n) :+MIDDLE LEVEL       │
       └────────────────────────────┘        └────────────────────────────┘
  S104 ┌────────────────────────────┐   S106 ┌────────────────────────────┐
       │    DETECT LEVEL ERRORS      │        │    DETECT LEVEL ERRORS      │
       └────────────────────────────┘        └────────────────────────────┘
```

# FIG. 5

START

S201
ARE y(t+n−2), y(t+n−1) AND y(t+n) ALL GREATER THAN Th?

NO

S207
n=n+1

YES

S204
ARE y(t+n−2), y(t+n−1) AND y(t+n) ALL LESS THAN Th?

NO

S202
y(t+n−1):+MAXIMUM LEVEL

YES

S205
y(t+n−1):−MAXIMUM LEVEL

S203
DETECT LEVEL ERRORS

S206
DETECT LEVEL ERRORS

EP 1 098 313 A2

# FIG. 6

START

S307

S301
$y(t+n-1) \times y(t+n) \leq 0?$ — NO

$n = n+1$

YES

S302
$|y(t+n-1)| \leq |y(t+n)|?$ — NO

S303
$y(t+n-1)$: ZERO LEVEL

S305
$y(t+n)$ : ZERO LEVEL

S304
DETECT LEVEL ERRORS

S306
DETECT LEVEL ERRORS

# FIG. 7

START

S401 — $y(t+n-2) \times y(t+n-1) \leq 0?$ — NO → S413 $n=n+1$

YES

S402 — $|y(t+n-2)| < |y(t+n-1)|?$ — NO

YES

S403 — $y(t+n-1) > 0?$ — NO

S408 — $y(t+n-2) > 0?$ — NO

YES (S404)
$y(t+n-1):+\text{MIDDLE LEVEL}$
$y(t+n-3):-\text{MIDDLE LEVEL}$

S406
$y(t+n-1):-\text{MIDDLE LEVEL}$
$y(t+n-3):+\text{MIDDLE LEVEL}$

YES (S409)
$y(t+n-2):+\text{MIDDLE LEVEL}$
$y(t+n):-\text{MIDDLE LEVEL}$

S411
$y(t+n-2):-\text{MIDDLE LEVEL}$
$y(t+n):+\text{MIDDLE LEVEL}$

S405 DETECT LEVEL ERROR

S407 DETECT LEVEL ERROR

S410 DETECT LEVEL ERROR

S412 DETECT LEVEL ERROR

EP 1 098 313 A2

# FIG. 8

NRZI SIGNAL → MTF → x → FIR (106) → VITERBI DETECTOR (114) → REPRODUCTION DATA

COEFFICIENT ADAPTER (1122)

PR Model

Weq

d + − y

e

1121

112

## FIG. 9

## FIG. 10

# FIG. 11

EP 1 098 313 A2

# FIG. 12A

TANGENTIAL TILT(degree)

# FIG. 12B

TANGENTIAL TILT(degree)

# FIG. 12C

## FIG. 13

## FIG. 14

# FIG. 15

EP 1 098 313 A2

FIG. 16

EP 1 098 313 A2

# FIG. 17A

Defocus(um)

# FIG. 17B

Defocus(um)

# FIG. 17C

# FIG. 18A

TANGENTIAL TILT(degrees)

# FIG. 18B

TANGENTIAL TILT(degrees)

# FIG. 18C

## FIG. 19

START

RECEIVE SERVO ABNORMAL SIGNAL — S501

S502 — DOES Kc INCREASE? — NO → S507 — DOES Kc DECREASE? — NO

YES ↓

S503 — DOES Kc INCREASE? — NO → S505 — DOES Kc DECREASE? — NO

YES ↓

S504 — OUTPU DEFOCUS SIGNAL

YES ↓ S506 — OUTPUT TANGENTIAL TILLT SIGNAL t_tilt_l (or t_tilt_r)

S507 DOES Kc DECREASE? — YES ↓

S508 — DOES Kc INCREASE? — NO

YES ↓ S509 — OUTPUT TANGENTIAL TILLT SIGNAL t_tilt_r (or t_tilt_l)

END

EP 1 098 313 A2